Europäisches Patentamt

European Patent Office

Office européen des brevets

(19)

(11) Veröffentlichungsnummer: **0 239 862**
**B1**

(12) **EUROPÄISCHE PATENTSCHRIFT**

(45) Veröffentlichungstag der Patentschrift:
07.02.90

(51) Int. Cl.⁴: **H03K 17/16**

(21) Anmeldenummer: 87103849.3

(22) Anmeldetag: 17.03.87

(54) Ansteuerschaltung für einen Leistungs-MOSFET mit sourceseitiger Last.

(30) Priorität: 19.03.86 DE 3609236

(43) Veröffentlichungstag der Anmeldung:
07.10.87 Patentblatt 87/41

(45) Bekanntmachung des Hinweises auf die Patenterteilung:
07.02.90 Patentblatt 90/6

(84) Benannte Vertragsstaaten:
DE FR GB IT SE

(56) Entgegenhaltungen:
US-A- 3 403 270

INSTRUMENTS AND EXPERIMENTAL TECHNIQUES,
Band 27, Nr. 5, Teil 1, September/Oktober 1984,
Seiten 1159-1161, Plenum Publishing Corp., New York,
US; V.V. BACHURIN et al.: "Heavy-current nanosecond
pulse shapers using high-power MOS transistors with a
vertical channel" 5-80B. VYS. TEMP., [MATER.-VSES.
SOVESHCH. FIZ.-KHIM. OSN. SOZDANIYA
ZHAROPROCHN. ME 000
PATENT ABSTRACTS OF JAPAN, Band 1,
Nr. 124 (E-77), 18. Oktober 1977, Seite 5300 E 77 &
JP-A-52-57 769
PATENT ABSTRACTS OF JAPAN, Band 8,
Nr. 127 (E-250)[1564], 14. Juni 1984 & JP-A-59-39 122

(73) Patentinhaber: Siemens Aktiengesellschaft,
Wittelsbacherplatz 2, D-8000 München 2(DE)

(72) Erfinder: Einzinger, Josef, Dipl.-Ing., Am Weiher 21,
D-8044 Unterschleissheim(DE)
Erfinder: Fellinger, Christine, Von Stauffenberg
Strasse 3, D-8025 Unterhaching(DE)
Erfinder: Leipold, Ludwig, Dipl.-Ing., Strassberger
Strasse 125, D-8000 München 40(DE)
Erfinder: Tihanyi, Jenö, Dr., Windeck 1 d,,
D-8000 München 70(DE)
Erfinder: Weber, Roland, Dipl.-Ing., Ursulastrasse 5,,
D-8000 München 40(DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf eine Ansteuerschaltung für einen Leistungs-MOSFET mit zwischen seinem Sourceanschluß und Massepotential liegender Last und mit einem einerseits mit Massepotential und andererseits mit dem Gateanschluß des Leistungs-MOSFET verbundenen elektronischen Schalter.

Eine solche Ansteuerschaltung ist beispielsweise in der Zeitschrift "elektronik industrie" 4-1985, Seiten 32 bis 38 beschrieben worden. Sie weist eine Vielzahl von elektronischen Bauelementen auf, die logische Verknüpfungen und Schaltfunktionen ausführen. Der Ausgang des elektronischen Schalters ist mit dem Gateanschluß eines Leistungs-MOSFET verbunden, dem sourceseitig eine Last in Reihe geschaltet ist. Diese Last liegt auf der dem MOSFET abgewandten Seite an Masse. Der elektronische Schalter selbst ist ebenfalls mit Massepotential verbunden.

In vielen Fällen, z. B. bei Bordnetzen von Kraftfahrzeugen, ist derjenige Masseanschluß, mit dem der elektronische Schalter verbunden ist, nicht identisch mit demjenigen Masseanschluß, an dem die Last liegt. Kommt es nun beispielsweise durch Erschütterungen oder Korrosion zu einer Unterbrechung zwischen Massepotential und der zum Anschluß an Massepotential bestimmten Klemme des elektronischen Schalters, so ändert sich sein Ausgangspotential. Damit ändert sich auch das Gatepotential des Leistungs-MOSFET, so daß er teilweise eingeschaltet werden kann. Dann wird im Leistungs-MOSFET eine erhebliche Verlustleistung umgesetzt.

Der Erfindung liegt die Aufgabe zugrunde, eine Ansteuerschaltung der erwähnten Gattung so weiterzubilden, daß ein teilweises Einschalten des Leistungs-MOSFET bei Unterbrechung zwischen dem elektronischen Schalter und Massepotential vermieden wird.

Diese Aufgabe wird dadurch gelöst, daß zwischen Source- und Gateanschluß des Leistungs-MOSFET die Source-Drain-Strecke eines Depletion-MOSFET angeschlossen ist und daß der Gateanschluß des Depletion-MOSFET mit einer zur Verbindung mit Massepotential bestimmten Klemme des elektronischen Schalters verbunden ist.

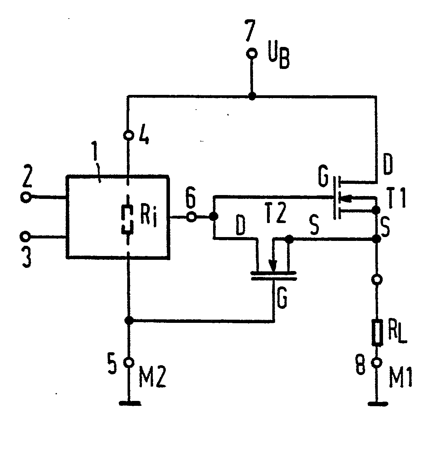

Die Erfindung wird anhand eines Ausführungsbeispiels in Verbindung mit der einzigen Figur näher erläutert:

In der Figur ist ein Leistungs-MOSFET T 1 dargestellt, dem sourceseitig eine Last $R_L$ in Reihe geschaltet ist. Der Drainanschluß D von T 1 liegt an einer Klemme 7, während der von T 1 abgewandte Anschluß der Last mit einer Klemme 8 verbunden ist. Diese Klemme 8 liegt an Massepotential M 1. An die Klemmen 7, 8 wird eine Versorgungsspannung, beispielsweise eine Batteriespannung $U_B$ angelegt.

Die Ansteuerschaltung weist einen elektronischen Schalter 1 mit mehreren Eingangsklemmen auf, von denen hier lediglich zwei dargestellt und mit 2, 3 bezeichnet sind. Der elektronische Schalter 1 enthält Halbleiterbauelemente, deren konkrete Ausführung und Verknüpfung nicht wesentlich ist. Die Gesamtheit der elektronischen Bauelemente ist daher lediglich durch einen Innenwiderstand $R_i$ symbolisiert. Der elektronische Schalter hat zwei Klemmen 4, 5, an denen die Versorgungsspannung liegt. Dabei ist die Klemme 5 mit einem Massepotential M 2 verbunden. Die Massepotentiale M 1 und M 2 werden beispielsweise durch verschiedene Stellen der Karosserie eines Kfz gebildet. Der elektronische Schalter hat weiter eine Ausgangsklemme 6, an der abhängig von Signalen an den Eingangsklemmen 2, 3 eine Spannung auftritt. Die Ausgangsklemme 6 ist mit dem Gateanschluß G von T 1 verbunden. Die an der Ausgangsklemme 6 auftretende Spannung dient dazu, den Leistungs-MOSFET T 1 einzuschalten.

Zwischen dem Sourceanschluß S und dem Gateanschluß G von T 1 liegt die Source-Drain-Strecke eines Depletion-MOSFET T 2. Dieser hat einen Gateanschluß, der mit der Klemme 5 des elektronischen Schalters 1 verbunden ist. Die Klemme 5 ist Teil des elektronischen Schalters.

Zur Erläuterung der Funktion der Schaltungsanordnung wird zunächst angenommen, daß der elektronische Schalter 1 ordnungsgemäß über seine Klemme 5 mit der Masse M 2 verbunden und der Leistungs-MOSFET T 1 gesperrt ist. Erscheint nun an der Ausgangsklemme 6 eine positive Spannung, liegt diese sowohl am Drainanschluß von T 2 als auch am Gateanschluß von T 1. Da der Sourceanschluß beider Transistoren und der Gateanschluß von T 2 auf Massepotential liegt, ist T 2 leitend. Der Depletion-Transistor T 2 ist so dimensioniert, daß er bei $U_{GS} = 0$ V weniger Strom zieht als der elektronische Schalter an seiner Ausgangsklemme 6 liefert. Damit fließt Strom in die Gate-Source-Kapazität von T 1 und T 1 wird eingeschaltet. Beim Einschalten steigt das Sourcepotential beider Transistoren in Richtung auf die Batteriespannung an. Dadurch erhält T 2 eine negative Gate-Source-Vorspannung und sperrt, wenn das Potential am Gate um die Einsatzspannung niedriger ist als das Sourcepotential. Das Potential an der Klemme 6 steigt nun ebenfalls an und erreicht einen Wert, der höher ist als die Batteriespannung $U_B$. Dies kann durch einen speziellen Aufbau des elektronischen Schalters mit einer Ladungspumpe erreicht werden, wie sie z. B. in der Zeitschrift "Siemens Components", Nr. 4/84, Seiten 169 bis 170 beschrieben ist.

Wird im ausgeschalteten Zustande von T 1 die Verbindung zwischen Klemme 5 und Massepotential M 2 unterbrochen, so steigt das Bezugspotential an der Klemme 5 des elektronischen Schalters 1 bedingt durch Sperrströme der in ihm enthaltenen elektronischen Bauelemente in Richtung der Spannung $U_B$ an. Damit steigt auch das Potential am Gateanschluß von T 2 gegenüber seinem Sourcepotential an und der Transistor wird vollständig leitend. Der an der Ausgangsklemme 6 auftretende Strom fließt daher nur noch durch T 2 durch die Last $R_L$ nach Masse M 1 ab, so daß der Leistungs-MOSFET T 1 nicht eingeschaltet werden kann.

Im Extremfall kann die Spannung zwischen Gateanschluß und Sourceanschluß, d. h. dem Halbleiterkörper von T 2 so groß wie die Betriebsspannung

$U_B$ werden. Die Gate-Isolierschicht (Gateoxid) muß daher eine solche Dicke haben, daß es in diesem Fall nicht zu einem Durchbruch des Gateoxids kommt. Für eine Durchbruchsspannung von z. B. 100 V erhält das Gateoxid eine Dicke von 200 nm.

**Patentansprüche**

1. Ansteuerschaltung für einen Leistungs-MOSFET mit zwischen seinem Sourceanschluß und Massepotential liegender Last und mit einem einerseits mit Massepotential und andererseits mit dem Gateanschluß des Leistungs-MOSFET verbundenen elektronischen Schalter, **dadurch gekennzeichnet,** daß zwischen Source- und Gateanschluß (S, G) des Leistungs-MOSFET (T 1) die Source-Drain-Strecke eines Depletion-MOSFET (T 2) angeschlossen ist und daß der Gateanschluß (G) des Depletion-MOSFET mit einer zur Verbindung mit Massepotential bestimmten Klemme (5) des elektronischen Schalters (1) verbunden ist.

2. Schaltungsanordnung nach Anspruch 1, **dadurch gekennzeichnet,** daß die Durchbruchsspannung zwischen der Gateelektrode (G) und dem Halbleiterkörper des Depletion-MOSFET (T 2) mindestens so groß wie die Versorgungsspannung ($+U_B$) ist.

**Claims**

1. Drive circuit for a power MOSFET having a load connected between its source electrode and ground potential and having an electronic switch connected on the one hand to ground potential and on the other hand to the gate electrode of the power MOSFET, characterized in that the source-drain path of a depletion-mode MOSFET (T2) is connected between the source and gate electrodes (S, G) of the power MOSFET (T1), and in that the gate electrode (G) of the depletion-mode MOSFET is connected to a terminal (5) of the electronic switch (1) which is intended for connection to ground potential.

2. Circuit arrangement according to Claim 1, characterized in that the breakdown voltage between the gate electrode (G) and the semiconductor body of the depletionmode MOSFET (T2) is at least as high as the supply voltage ($+U_B$).

**Revendications**

1. Circuit d'attaque pour un MOSFET de puissance, avec une charge située entre sa borne de source et le potentiel de masse, et avec un interrupteur électronique relié, d'une part, au potentiel de masse, et, d'autre part à la borne de grille du MOSFET de puissance, caractérisé par le fait qu'entre la borne de source et la borne de grille (S, G) du MOSFET de puissance (T1) est relié le circuit source-drain d'un MOSFET à déplétion (T2), et que la borne de grille (G) du MOSFET à déplétion est reliée à une borne (5) de l'interrupteur électronique (1), qui est destinée à la liaison avec le potentiel de masse.

2. Montage selon la revendication 1, caractérisé par le fait que la tension de claquage entre l'électrode de grille (G) et le corps semiconducteur du MOSFET à déplétion (T2) est au moins égale à la tension d'alimentation ($+ U_B$).